# EUROPÄISCHE PATENTSCHRIFT

(11) **EP 0 315 986 B1**
(45) Veröffentlichungstag und Bekanntmachung des Hinweises auf die Patenterteilung: **17.08.1994**
(21) Anmeldenummer: 88118738.9
(22) Anmeldetag: 10.11.1988
(51) Int. Cl.: H01J 27/18

(54) **Filamentlose Magnetron-Ionenquelle und Verwendungsverfahren**
Filamentless magnetron ion source and its utilization process
Source d'ions magnétron sans filament et son procédé d'utilisation

(30) Priorität: 11.11.1987 DE 3738352
(43) Veröffentlichungstag der Anmeldung: 17.05.1989
(73) Patentinhaber: TECHNICS PLASMA GMBH, 85551 Kirchheim (DE)
(72) Erfinder: Möhl, Wolfgang, Dr, Dipl.-Phys., D-8011 Kirchheim bei München (DE)
(74) Vertreter: Boeters, Hans Dietrich, Dr.

(56) Entgegenhaltungen:
- EP-A- 0 315 986
- US-A- 4 585 668
- JOURNAL OF VACUUM SCIENCE & TECHNOLOGY B, Band 5, Nr. 1, Januar-Februar 1987, Seiten 328-331, Second Series, New York; US; J. ASMUSSEN et al.: "The experimental test of a microwave ion beam source in oxygen"

## Beschreibung

Die Erfindung betrifft eine filamentlose Ionenquelle und deren Verwendung.

Die bekannte elektrostatische Kaufman-Ionenquelle (US-A-3 156 090) sieht eine Ionenerzeugung durch elektrostatische Felder vor. Dazu sind ein Elektronenemitter (Glühkathode) und metallische Elektroden in der Plasmakammer notwendig. Die Kontamination des Plasmas durch Sputterprodukte der metallischen Elektroden ist jedoch unerwünscht.

Weiterentwicklungen, z.B. die von Sakudo et al., führten zu Ionenquellen, die ohne Glühkathode arbeiten. Solche Ionenquellen sind mit einem 2,4 GHz-Magnetron, einem Hohlleiter, einem Kurzschlußschieber, DC-Magneten und Extraktionselektroden ausgestattet (US-A-4 058 748). Es ist jedoch schwierig, die Ionisierungskammer gegenüber dem Magnetron vakuumdicht zu verschließen. Hierzu wurden bisher Scheiben aus einem Dielektrikum wie Bornitrid vorgeschlagen (US-A-4 058 748, 4 316 090, 4 393 333, 4 409 520). Außerdem ergibt sich der Nachteil, daß der Kontakt des Gases mit dem metallischen Wellenleiter zur Erzeugung von Sputterprodukten führt. Durch die Verunreinigung des Gases können unerwünschte Implantationen oder Dotierungen auf dem Substrat entstehen.

Bei einer weiteren bekannten Bauform wird das Substrat auf einer Substrat-Plattform direkt in der Ionisationskammer behandelt (US-A-4 438 368).

Journal of Vacuum Science and Technology B, Bd. 5, Nr. 1, 1987, S. 328 - 331, WO-A 87/07760 (entsprechend der älteren Anmeldung EP-A-87 904 753.8) und US-A-4 585 668, betreffen sämtlich eine von Jes Asmussen entwickelte Ionenquelle. Mehr im einzelnen beschreibt erstere Publikation die Mikrowellen-Einkopplung über eine Koaxialleitung, wobei ein Kurzschlußschieber zur Impedanzanpassung vorgesehen ist. Mittels ECR-Magneten wird der Zündvorgang bewirkt. Eine Quarzplatte oder -kuppel begrenzt den Plasmabereich. Die Asmussen-Ionenquelle ist relativ einfach aufgebaut und zuverlässig. Indessen sind keinerlei Kopplungsmaßnahmen getroffen worden, um den Q-Faktor zu erhöhen. Es ist zwar ein Kurzschlußschieber beschrieben, nicht jedoch ein λ/4-Kurzschlußschieber. Aufgrund der fehlenden Kopplungsmaßnahmen werden höhere Mikrowellenleistungen benötigt.

Die der Erfindung zugrundeliegende Aufgabe besteht darin, eine Ionenquelle zu schaffen, die eine besonderes gute Ionenausbeute gewährleistet.

Diese Aufgabe ist erfindungsgemäß bei einer Ionenquelle mit den Merkmalen des Anspruchs 1 gelöst. Vorteilhafte Weiterbildungen der erfindungsgemäßen Ionenquelle sind Gegenstand der abhängigen Ansprüche.

Eine erfindungsgemäße Ionenquelle umfaßt somit einen Mikrowellengenerator mit einem Magnetron zur Erzeugung von Mikrowellen mit einer Frequenz von 2,4 GHz, die mit einem Mikrowellen-Hohlleiter durch eine Hohlleiter-Iriskopplung in einen zylindrischen Hohlraumresonator geleitet werden, wobei zur Erzeugung der Mikrowellen im Hohlraumresonator ein Kurzschlußschieber mit λ/4-Choke vorgesehen ist, ECR-Magnete den Hohlraumresonator umgeben und ein Quarzdom das zu erzeugende Gasplasma umgibt.

Die Ionenerzeugung bei der erfindungsgemäßen Ionenquelle erfolgt über eine elektrodenlose Mikrowellengasentladung, die sich selbst aufrechterhält, so daß kein Elektrodenemitter (Glühkathode) benötigt wird. Gegenüber einer Anordnung mit Glühkathode und Anode wird die thermische Belastung drastisch gesenkt, die von der Ionenquelle auf das Substrat bzw. eine eingesetzte Materialprobe ausgeht.

Die Ionisationskammer ist von einem vorzugsweise kalottenförmigen Quarzdom umgeben, der das zu ionisierende Gas von sämtlichen Bauteilen des Wellenleiters abschirmt. Hierdurch gewinnt man auf elegante Weise ein von Sputterprodukten völlig reines Plasma. Gerade dies ist besonders wichtig, da das gewonnene Gas bevorzugt zum Ätzen von Substraten verwendet wird. Ein mit Verunreinigungen kontaminiertes Plasma würde unerwünscht zur Implantation von Sputterprodukten in den Substraten führen.

Wichtig bei der erfindungsgemäßen Ionenquelle ist der Einbau eines Kurzschlußschiebers mit λ/4-Choke. Dieser sorgt für einen ausgezeichneten Gleitkontakt zwischen dem Wellenleiter und dem zylindrischen Hohlraum-Resonator und bewirkt, daß der Resonator in optimaler Weise schwingt. Auf diese Weise werden Impedanz und Frequenz festgelegt und in gewünschter Weise im Hohlraumresonator Mikrowellen sowie der gewünschte Ionisationsgrad erzeugt. Die Hohlleiter-Iriskopplung ist ebenfalls zur Erzielung hoher Q-Faktoren sehr wichtig.

Durch die Kombination des Kurzschlußschiebers mit λ/4-Choke und der Hohlleiter-Iriskopplung ergibt sich eine sehr gute Ionenausbeute. Die weiteren Bauelemente der erfindungsgemäßen Ionenquelle sind bekannt und werden daher nicht weiter beschrieben.

Bei der erfindungsgemäßen Ionenquelle wird die Mikrowellenenergie in einen auf Resonanz abgestimmten Zylinderresonator eingekoppelt. Dieser gestattet vorteilhaft durch Variation seiner Länge in axialer Richtung ein Angleichen seiner Eigenfrequenz an die Magnetronfrequenz. In die vom Quarzdom umgebene Ionisationskammer strömt ein Gas, z.B. Argon, ein, das unter der Wirkung eines elektrischen Wechselfeldes zur Ionisation gebracht wird. Die Einleitung des Gases kann über ein ringförmiges Gaseinlaßsystem erfolgen.

Bei einer Ausführungsform der Erfindung wird das ionisierte Gas über ein Multiapertur - Elektrodenextraktionssystem in Form gerichteter Ionenstrahlen abgezogen und auf das zu ätzende Material gerichtet, das in einer sich anschließenden Vakuumkammer angeordnet ist. Das Extraktionssystem kann aus zwei oder drei aufeinanderfolgenden Graphitelektroden bestehen. Graphit ist bevorzugtes Material, da es inert ist und auch im Laufe der Zeit keine Ablagerungen auf der Oberfläche des Quarzdoms verursacht. Die Elektroden sind derart perforiert, daß sich die durch die Öffnungen austretenden Einzelstrahlen zu einem Breitstrahl überlappen.

Eine andere Variante des Ionenstrahlsystems stellt eine ECR-Plasmastromquelle dar (ECR = Elektron-Zyklotron-Resonanz). Hier ist anstelle des elektrostatischen Extraktionsgitter-Systems eine Öffnung (Orifice) vorgesehen, deren Durchmesser auf den Anwendungsmodus optimiert ist. Der Feldgradient des ECR-Magnetfeldes läßt einen elektrisch neutralen Plasmastrom entstehen, der durch die Öffnung entweicht.

Das erfindungsgemäße Ionenstrahlsystem eignet sich in besonders vorteilhafter Weise für Verfahren zum Ätzen von Substraten. ECR-Plasmastromquellen besitzen optimale Eigenschaften für niederenergetisches, anisotropes Ätzen. Der entstehende Plasmastrom verlangt keine Neutralisation.

Die erfindungsgemäße Vorrichtung wird nachstehend anhand von Figuren näher erläutert, die jeweils bevorzugte Ausführungsformen darstellen:
- Fig. 1: zeigt eine schematische Schnittansicht einer Ausführungsform der Ionenquelle gemäß der Erfindung;
- Fig. 2: zeigt eine Schnittansicht einer weiteren Ausführungsform der Ionenquelle gemäß der Erfindung; und
- Fig. 3: zeigt eine zum Teil geschnittene Ansicht einer weiteren Ausführungsform gemäß der Erfindung.

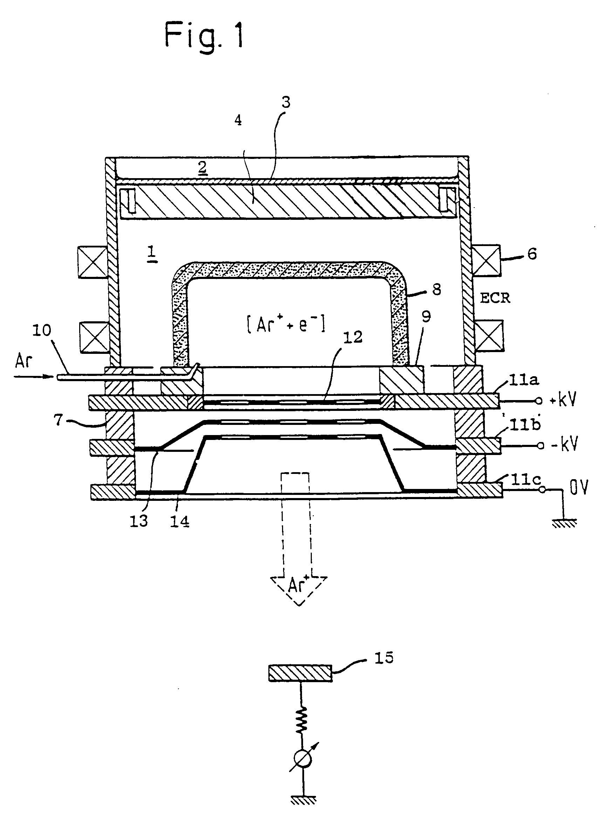

Bei der in Fig. 1 dargestellten Ausführungsform der Ionenquelle werden mit Hilfe eines nicht dargestellten Magnetrons bzw. Mikrowellengenerators Mikrowellen mit einer Frequenz von 2,4 GHz erzeugt. Die erzeugten Mikrowellen werden mit einem weggebrochenen Mikrowellen-Hohlleiter 2 in einen Hohlraumresonator 1 geleitet, der bei der Ausführungsform gemäß Fig. 1 die Form eines kurzen Zylinders besitzt. Bei der dargestellten Ausführungsform ist der Hohlraumresonator 1 durch einen Boden 3 verschlossen. Der Boden 3 trägt einen Kurzschlußschieber 4 mit λ/4-Choke und kann in Richtung auf den Quarzdom 8 oder in entgegengesetzter Richtung verschiebbar sein. Der Hohlraumresonator 1 wird von einem etwa zylindrischen Sockel 7 getragen, in den in drei verschiedenen Niveaus Isolatoren 11a, 11b und 11c eintreten. Diese Isolatoren 11a, 11b und 11c können beliebig gestaltet sein, beispielsweise scheiben- oder kranzförmig. Bei der dargestellten Ausführungsform ist der dem Quarzdom benachbarte Isolator 11a eine perforierte Scheibe, deren lichter Durchmesser deutlich geringer als der des Hohlraumresonators 1 ist, wobei der Isolator 11a wiederum einen ringförmigen Träger 9 von gleichem lichten Durchmesser trägt, auf dem der Quarzdom 8 aufsitzt. Die rohrförmige Gaszufuhr 10 ist durch Sockel 7 und den Quarzdomträger 9 geführt, so daß das zugeführte Gas, beispielsweise Argon, über eine Düse in den Quarzdom 8 eintritt. Die Isolatoren 11a, 11b und 11c halten Multiapertur-Extraktionselektroden 12, 13 und 14, vorzugsweise aus Graphit. Wie man Fig. 1 entnehmen kann, sind die Elektroden 12, 13 und 14 "abgeschattet", um einer Ablagerung von Material auf den Isolatoren vorzubeugen. Bei der dargestellten Ausführungsform fluchten die Öffnungen der Elektroden derart miteinander, daß sich ein Breitstrahl aus sich überlappenden Einzelstrahlen des Plasmas ergibt. Die Potentiale der einzelnen Elektroden sind Fig. 1 zu entnehmen. Der Träger 15 für das dem Plasmastrahl auszusetzende Substrat ist geerdet und nur schematisch dargestellt. ECR Magnetspulen 6 umgeben den Hohlraumresonator 1.

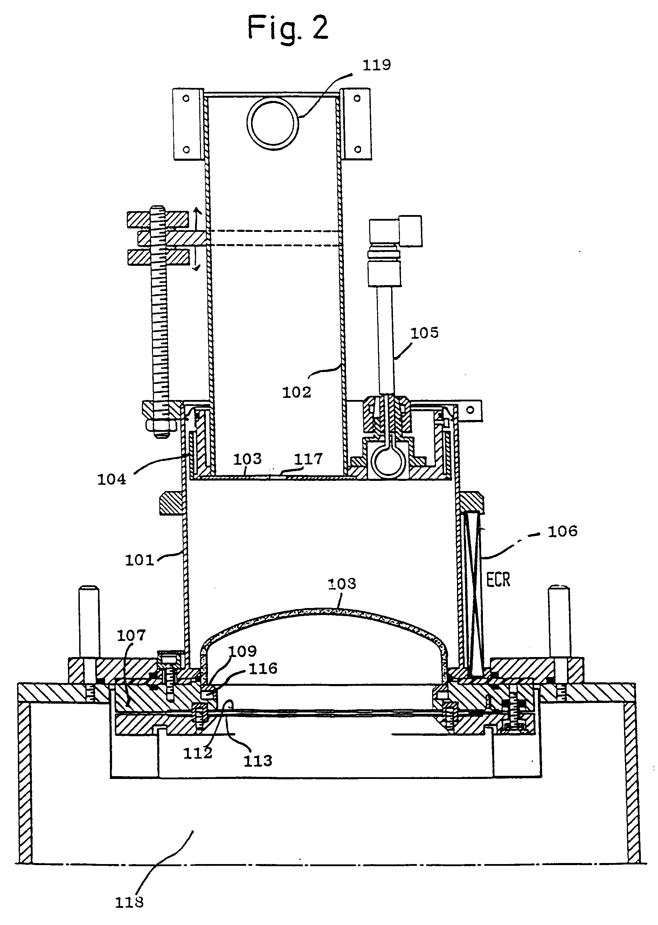

Nach Fig. 2 werden die von einem Magnetron 119 erzeugten Mikrowellen mit Hilfe eines Hohlleiters 102 über eine im Boden 103 des Hohlleiters 102 vorgesehene Iris 117 in den Hohlraumresonator 101 eingeführt. Eine eingezeichnete Koaxialleitung 105 ist nicht Teil der Erfindung.

Der Boden 103 trägt an seiner Peripherie einen Kurzschlußschieber 104 mit λ/4-Choke. Der Hohlleiter 102 ist an einer Gewindestange höhenverstellbar aufgehängt, wobei er im oberen Bereich des Hohlraumresonators 101 über einen federartigen metallischen Gleitkontakt mit dem Resonator 101 in Verbindung stehen kann.

Bei dieser Ausführungsform sitzt der Quarzdom 108 auf einem ringförmigen Träger 109 auf, der mit dem Sockel 107 einen ringförmigen Kanal, 116 bildet, über den das Gas mit Hilfe nicht dargestellter Öffnungen in den Quarzdom eingeleitet wird.

Bei der dargestellten Ausführungsform sind im Unterschied zu der Ausführungsform der Fig. 1 nur zwei Multiapertur-Extraktionselektroden 112, 113 vorgesehen.

Die ECR-Magnete 106 sind nur schematisch dargestellt. Der Reaktor 118 zur Einwirkung des Plasmas auf das vorgegebene Substrat ist im unteren Bereich weggebrochen.

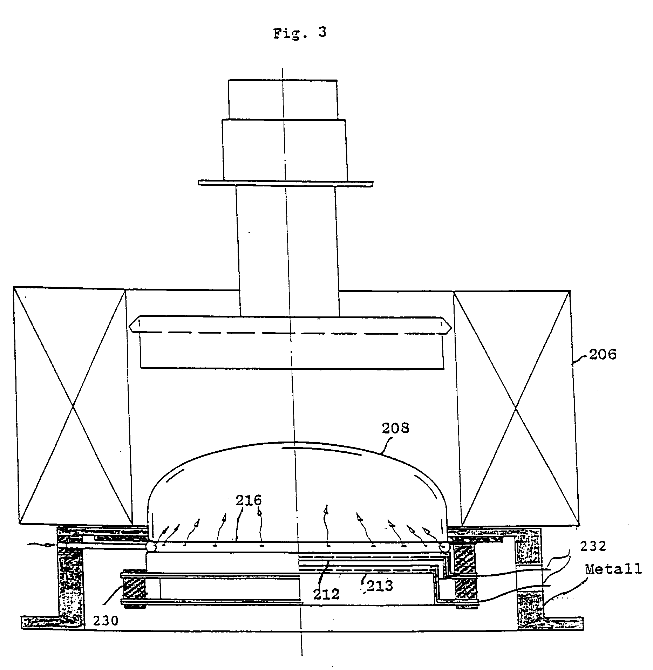

Bei der in Fig. 3 dargestellten Ausführungsform wird der Quarzdom 208 wiederum über eine Ringleitung 216 mit Gas versorgt. Wie bei der Ausführungsform der Fig. 2 sind in einem Isolator 230 gehalterte Doppelelektroden 212, 213 vorgesehen. Ein Stromanschluß ist bei 232 angedeutet.

## Patentansprüche

1. Ionenquelle, umfassend einen Mikrowellengenerator mit einem Magnetron (119) zur Erzeugung von Mikrowellen mit einer Frequenz von 2,4 GHz, die mit einem Mikrowellen-Hohlleiter (102) durch eine Hohlleiter-Iriskopplung (117) in einen zylindrischen Hohlraumresonator (1; 101) geleitet werden, wobei zur Erzeugung der Mikrowellen im Hohlraumresonator (1; 101) ein Kurzschlußschieber mit λ/4-Choke (4; 104) vorgesehen ist, ECR-Magnete (6; 106; 206) den Hohlraumresonator (1; 101), umgeben und ein Quarzdom (8; 108; 208) das zu erzeugende Gasplasma umgibt.

2. Ionenquelle nach Anspruch 1, dadurch **gekennzeichnet,** daß eine Multiapertur-Passage (12, 13, 14; 112, 113; 212, 213) zur Extraktion eines oder mehrerer gerichteter Ionenstrahlen und eine Vakuumkammer zur Einwirkung der Ionenstrahlen auf Materialproben vorgesehen ist.

3. Ionenquelle nach Anspruch 2, dadurch **gekennzeichnet,** daß die Multiapertur-Passage (12, 13, 14; 112, 113; 212, 213) aus mehreren hintereinander angeordneten Extraktionselektroden (12, 13, 14; 112, 113; 212, 213) gebildet ist.

4. Ionenquelle nach Anspruch 1, dadurch **gekennzeichnet,** daß eine Öffnung (Orifice) für den Durchtritt des Plasmas, deren Durchmesser auf den Anwendungsmodus optimiert ist, und eine Vakuumkammer zur Einwirkung der Ionenstrahlen auf Materialproben vorgesehen sind.

5. Ionenquelle nach einem der Ansprüche 1 bis 4, dadurch **gekennzeichnet,** daß sie ein ringförmiges, sich in den Quarzdom (8; 108) öffnendes Gaseinlaßsystem (116; 216) umfaßt.

6. Ionenquelle nach einem der Ansprüche 1 bis 5, dadurch **gekennzeichnet,** daß der Kurzschlußschieber mit λ/4-Choke (4; 104) in Richtung auf den Quarzdom (8; 108) und in die entgegengesetzte Richtung verschiebbar ist.

7. Verfahren zum Ätzen von Substraten, dadurch **gekennnzeichnet,** daß es unter Verwendung einer Ionenquelle nach einem der Ansprüche 2, 3, 5 oder 6 durchgeführt wird.

8. Verfahren zum niederenergetischen, anisotropen Ätzen von Substraten mit einem elektrisch neutralen Plasmastrom, dadurch **gekennzeichnet,** daß es unter Verwendung einer Ionenquelle nach einem der Ansprüche 1, 4 bis 6 durchgeführt wird.

## Claims

1. Ion source, comprising a microwave generator with a magnetron (119) to produce microwaves with a frequency of 2.4 GHz, which are led by a micro-waveguide (102) through a waveguide-iris coupling (117) into a cylindrical cavity resonator (1; 101), a short-circuit slider with λ/4-choke (4; 104) being provided to produce the microwaves in the cavity resonator (1; 101), ECR magnets (6; 106; 206) surrounding the cavity resonator (1; 101), and a quartz dome (8; 108; 208) surrounding the gas plasma to be produced.

2. Ion source according to Claim 1, characterised in that a multi-aperture passage (12, 13, 14; 112, 113; 212, 213) for the extraction of one or more directed ion beams and a vacuum chamber for the action of the ion beams on material samples are provided.

3. Ion source according to Claim 2, characterised in that the multi-aperture passage (12, 13, 14; 112, 113; 212, 213) is formed of a plurality of extraction electrodes (12, 13, 14; 112, 113; 212, 213) arranged one behind the other.

4. Ion source according to Claim 1, characterised in that an orifice for the passage of the plasma, the diameter of which orifice is optimised to the mode of application, and a vacuum chamber for the action of the ion beams on material samples are provided.

5. Ion source according to one of Claims 1 to 4, characterised in that it comprises an annular gas inlet system (116; 216) opening into the quartz dome (8; 108).

6. Ion source according to one of Claims 1 to 5, characterised in that the short-circuit slider with λ/4-choke (4; 104) is displaceable towards the quartz dome (8; 108) and in the opposite direction.

7. Method for etching substrates, characterised in that it is carried out using an ion source according to one of Claims 2, 3, 5 or 6.

8. Method for low-energy anisotropic etching of substrates with an electrically neutral plasma stream, characterised in that it is carried out using an ion source according to one of Claims 1, 4 to 6.

## Revendications

1. Source d'ions, comprenant un générateur de micro-ondes qui comporte un magnétron (119) destiné à produire des micro-ondes qui ont une fréquence égale à 2,4 GHz et qui, au moyen d'un guide d'ondes (102) pour micro-ondes, sont guidées vers une cavité résonnante (1 ; 101) cylindrique en passant par un couplage de guide d'ondes à iris (117), tandis que, pour la production des micro-ondes dans la cavité résonnante (1 ; 101), il est prévu un volet de court-circuit à étranglement λ/4 (4 ; 104), des aimants ECR (résonance électron-cyclotron) (6 ; 106 ; 206) entourent la cavité résonnante (1; 101) et un dôme en quartz (8 ; 108 ; 208) entoure le plasma gazeux à produire.

2. Source d'ions suivant la revendication 1, caractérisée en ce qu'il est prévu un passage multi-ouvertures (12, 13, 14 ; 112, 113 ; 212, 213), servant à extraire un ou plusieurs faisceaux ioniques dirigés, et une chambre à vide permettant aux faisceaux ioniques d'agir sur des échantillons de matière.

3. Source d'ions suivant la revendication 2, caractérisée en ce que le passage multi-ouvertures (12, 13, 14 ; 112, 113 ; 212, 213) est constitué de plusieurs électrodes d'extraction (12, 13, 14; 112, 113; 212, 213) disposées l'une derrière l'autre.

4. Source d'ions suivant la revendication 1, caractérisée en ce qu'il est prévu une ouverture (orifice calibré), qui est destinée au passage du plasma et dont le diamètre est adapté d'une manière optimale au mode d'utilisation, et une chambre à vide permettant aux faisceaux ioniques d'agir sur des échantillons de matière.

5. Source d'ions suivant l'une des revendications 1 à 4, caractérisée en ce qu'elle comprend un système d'entrée de gaz (116 ; 216) annulaire qui débouche dans le dôme en quartz (8 ; 108).

6. Source d'ions suivant l'une des revendications 1 à 5, caractérisée en ce que le volet de court-circuit à étranglement λ/4 (4 ; 104) est agencé de façon à pouvoir être déplacé en translation en direction du dôme en quartz (8 ; 108) et dans la direction opposée.

7. Procédé d'usinage de substrats par corrosion, caractérisé en ce qu'il est mis en oeuvre en utilisant une source d'ions suivant l'une des revendications 2, 3, 5 ou 6.

8. Procédé d'usinage de substrats par corrosion, de type anisotrope et à faible énergie, au moyen d'un courant de plasma électriquement neutre, caractérisé en ce qu'il est mis en oeuvre en utilisant une source d'ions suivant l'une des revendications 1 et 4 à 6.
